Europäisches Patentamt

European Patent Office

Office européen des brevets

(11) Publication number: **0 314 461**
**A2**

# EUROPEAN PATENT APPLICATION

(21) Application number: **88310076.0**

(22) Date of filing: **26.10.88**

(51) Int. Cl.⁴: **H 03 K 4/69**

(30) Priority: **28.10.87 GB 8725295   15.06.88 US 206780**

(43) Date of publication of application:
**03.05.89   Bulletin   89/18**

(84) Designated Contracting States: **DE ES FR GB IT**

(71) Applicant: **RCA LICENSING CORPORATION
2 Independence Way
Princeton New Jersey 08540   (US)**

(72) Inventor: **Leonardi, Giovanni Michele
Dennlerstrasse 20a
CH-8048 Zurich   (CH)**

(74) Representative: **Pratt, Richard Wilson et al
London Patent Operation G.E. TECHNICAL SERVICES
CO. INC. Burdett House 15/16 Buckingham Street
London WC2N 6DU   (GB)**

(54) Vertical deflection apparatus.

(57) A vertical deflection current generator includes an operational amplifier (31) responsive to an input sawtooth signal ($V_S$) at a vertical rate. A first end terminal of a deflection winding ($L_V$) is coupled to an output terminal (31a) of the amplifier (31). A second end terminal (60) of the deflection winding ($L_V$) is coupled in series with a parallel arrangement of a switch (32) and a capacitor ($C_R$). The switch (32) is conductive during vertical trace. During vertical retrace, the switch (32) is nonconductive, which causes a vertical retrace voltage ($V_{CR}$) to develop in a flyback manner in the retrace capacitor ($C_R$). The retrace voltage ($V_{CR}$) in the retrace capacitor ($C_R$) and a retrace voltage ($V_v$) at the output terminal (31a) of the amplifier (31) are opposite in phase and speed up the reversal of deflection current in the deflection winding ($L_V$).

*FIG. 1*

## Description

## VERTICAL DEFLECTION APPARATUS

This application relates to a vertical deflection apparatus for a video apparatus, e.g. a television apparatus.

To provide vertical trace current to a vertical deflection winding, a conventional vertical deflection circuit, operating at a standard field rate of, for example, 50Hz in PAL systems, includes, for example, two output transistors forming a push-pull output stage. The output stage drives the deflection winding. During vertical retrace, the direction of the current in the deflection winding is reversed to be ready for the next trace interval.

One prior art vertical deflection circuit operating at a standard vertical rate includes a retrace capacitor coupled to the deflection winding to form a resonant retrace circuit for generating a resonant retrace current. The retrace capacitor is coupled at a junction between the deflection winding and an output terminal of the output stage. During vertical retrace, the transistors of the output stage are switched off; therefore, the duration of vertical retrace interval is determined by the retrace voltage across the retrace capacitor.

The threshold of perception of field flicker in a television display system is a function of the field frequency and the brightness of the display. Over the years, displays have increased in brightness to the point where flicker is noticeable even in relatively high field rate systems (e.g., the NTSC 60 Hz system) and clearly objectionable in lower field rate systems (e.g., the PAL 50 Hz system). A solution to this problem is to double the field rate of the deflection current causing the rate of displaying the images to double. Consequently, it may be desirable to shorten the vertical retrace interval in the vertical deflection current that is at double the field rate, relative to that in the typical generator that generates the deflection current at a standard field rate.

A vertical deflection current generator, embodying an aspect of the invention, includes an operational amplifier responsive to an input sawtooth signal at double the standard vertical rate. A first end terminal of a deflection winding is coupled to an output terminal of the amplifier. A second end terminal of the deflection winding is coupled to a switch that is conductive during vertical trace. A retrace capacitor is coupled across the switch. During vertical retrace, the switch becomes nonconductive that causes vertical retrace voltage to develop in a flyback manner across the retrace capacitor. The retrace voltage across the retrace capacitor that is coupled to the second end terminal of the deflection winding, and a retrace voltage at the output terminal of the amplifier that is coupled to the first terminal, that are opposite in phase, speed up the reversal of the deflection current in the deflection winding. Speeding up of the retrace interval occurs because the resultant retrace voltage across the deflection winding is higher than the retrace voltage that would have been developed had only one retrace voltage been applied. In this way, the two oppositely phased retrace voltages, one produced at the output of the amplifier and the other across the retrace capacitor, are developed across the vertical deflection winding. The retrace voltages cause the rate of change of the vertical deflection current to be high during vertical retrace. The result is that the vertical retrace interval is shortened relative to that of a conventional vertical deflection generator that develops only one retrace voltage.

A deflection apparatus embodying another aspect of the invention, includes a source of a sawtooth signal at a frequency that is related to a vertical deflection frequency. The apparatus includes a vertical deflection winding for conducting therein a deflection current. A retrace pulse voltage is generated at a second terminal. A sawtooth output voltage having a retrace pulse voltage portion that is oppositely directed to that retrace pulse voltage at a second terminal and that is coupled to the deflection winding is generated. The deflection winding is interposed between the first and second terminals.

In the Drawing:

FIGURE 1 illustrates an illustrative example of a television vertical deflection circuit, embodying an aspect of the invention;

FIGURES 2a-2g illustrate waveforms useful in explaining the operation of the circuit of FIGURE 1;

FIGURE 3 illustrates a second illustrative embodiment of the invention; and

FIGURES 4a and 4b illustrate the characteristics of a bipolar transistor and of an MOS FET, respectively, that may be used to perform switching operation in the circuit of FIGURE 1.

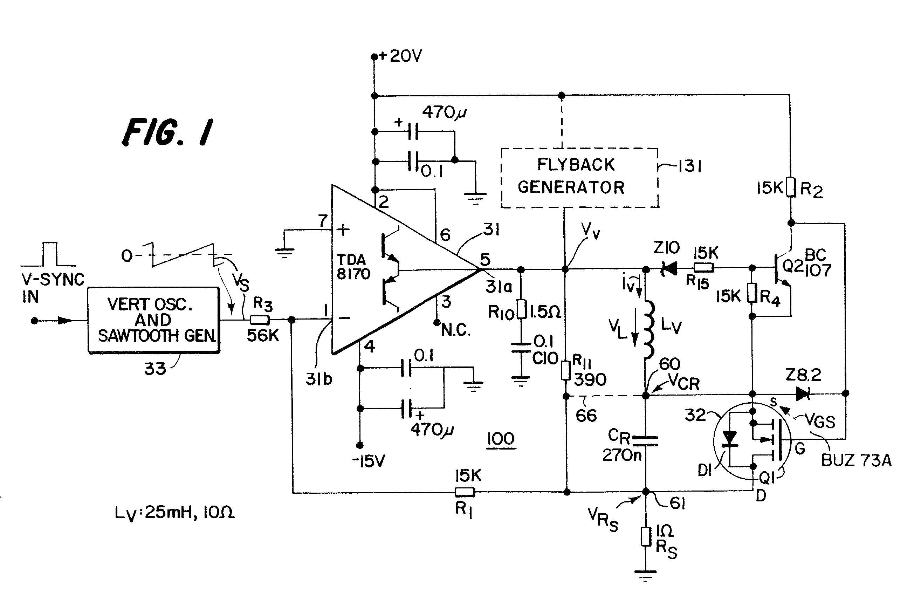

FIGURE 1 illustrates a vertical deflection circuit 100, embodying an aspect of the invention. Deflection circuit 100 includes an operational amplifier 31 utilizing integrated circuit (IC) technology having an inverting input terminal $31b$ that is responsive to a sawtooth signal $V_s$. Signal $V_s$ that is developed at a rate of, for example, 100Hz, or twice the standard field rate, is produced in a vertical oscillator and sawtooth generator 33 and coupled via a resistor $R_3$ to inverting input terminal $31b$ of amplifier 31. An output terminal $31a$ of amplifier 31 is coupled to one end terminal of a vertical deflection winding $L_v$. A second end terminal of winding $L_v$ is coupled via a junction terminal 60 to a first terminal of a vertical retrace capacitor $C_R$ and to a main current conducting terminal of a switching arrangement 32. Switching arrangement 32 includes, for example, a MOS-FET Q1 and a diode D1 that is coupled in parallel with transistor Q1. Switching arrangement 32 is coupled in parallel with capacitor $C_R$, and has a second main current conducting terminal that is coupled to a junction terminal 61. A vertical current sampling resistor $R_s$ is coupled between terminal 61 and ground. A negative feedback providing resistor $R_1$ has one end terminal that is coupled to terminal 61 and a second end terminal that is coupled to inverting input terminal $31b$ of amplifier 31.

A cathode electrode of a 10 volt zener diode Z10 is coupled to output terminal 31a of amplifier 31. The anode electrode of zener diode Z10 is coupled via a resistor $R_{15}$ to a base electrode of a switching transistor Q2. The collector electrode of transistor Q2 is coupled through a load resistor $R_2$ to a supply voltage of, for example, +20 volts that also energizes amplifier 31. The collector electrode of transistor Q2 is coupled to a gate electrode of transistor Q1 of arrangement 32 for controlling the switching operation of transistor Q1. Transistor Q2 causes transistor Q1 to be conductive during vertical trace, as described later on. Transistor Q2 causes transistor Q1 to become nonconductive during vertical retrace. A flyback retrace pulse voltage $V_{CR}$, embodying a feature of the invention, is developed across capacitor $C_R$ when switching arrangement 32 is nonconductive. Resistors $R_{10}$ and $R_{11}$ and a capacitor $C_{10}$ provide oscillation damping during trace.

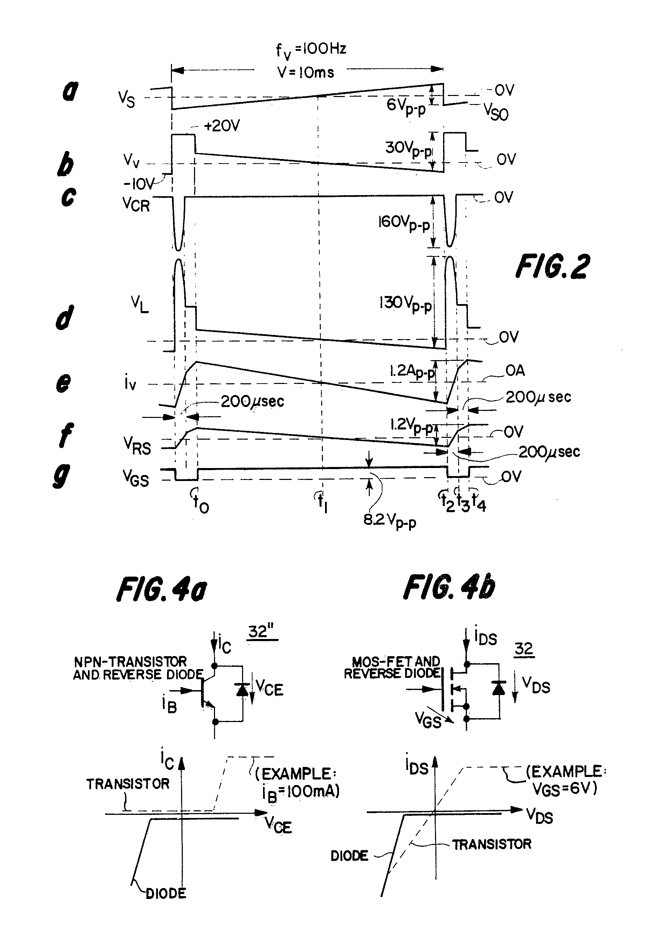

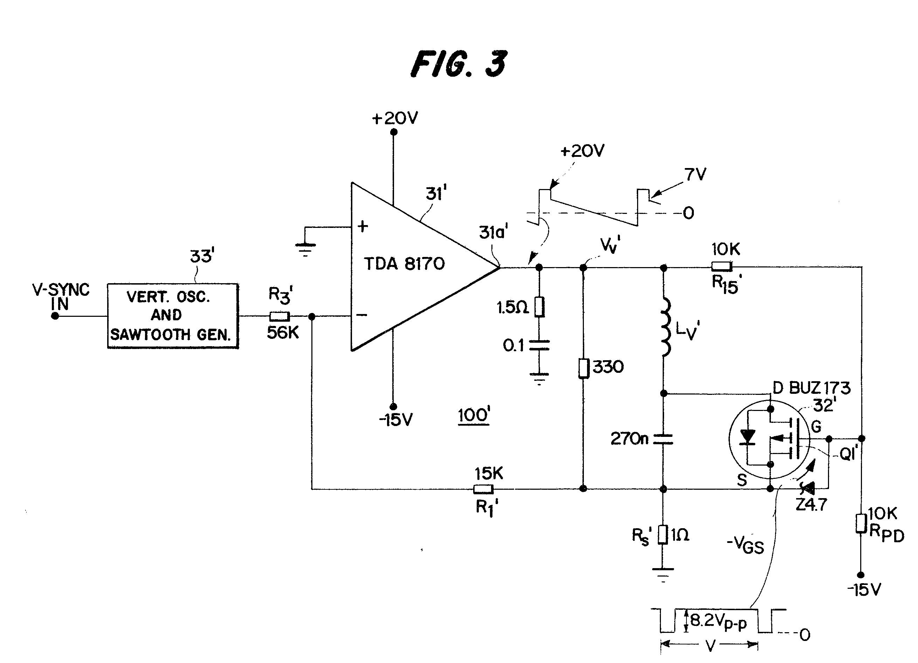

FIGURES 2a-2g illustrate waveforms useful in explaining the operation of the circuit of FIGURE 1. Similar symbols and numerals in FIGURES 1 and 2a-2g indicate similar items or functions.

Throughout an interval $t_0$-$t_2$ of FIGURE 2b, representing vertical trace, a voltage $V_v$ at output terminal 31a of amplifier 31 of FIGURE 1 is less positive than +10 volts. Therefore, zener diode Z10 is nonconductive, causing transistor Q2 to be nonconductive. When transistor Q2 is nonconductive, it causes the gate-source voltage of transistor Q1, that is clamped to 8.2 volts by an 8.2 volt zener diode Z8.2, to be higher than the turn-on threshold voltage of transistor Q1. Therefore, during vertical trace, transistor Q1 is turned-on. A resistor $R_4$ prevents the base electrode voltage of transistor Q2 from becoming lower than 6 volts during vertical trace.

During a portion $t_0$-$t_1$, representing the first half of the trace interval of FIGURE 2e, a positive current $i_v$ flows through winding $L_v$ and diode D1 of switching arrangement 32 of FIGURE 1. Between time $t_1$ and $t_2$ of FIGURE 2e, forming the second half of vertical trace, negative current $i_v$ flows through winding $L_v$ and through MOS power transistor Q1 of FIGURE 1. Therefore, throughout vertical trace, capacitor $C_R$ is short-circuited or bypassed. At time $t_2$ of FIGURE 2a, at the end of trace and at the beginning of vertical retrace, voltage $V_s$ produced by generator 33 of FIGURE 1 reverses its direction. Therefore, voltage $V_s$ is established at a level $V_{so}$ of FIGURE 2a. Consequently, amplifier 31 of FIGURE 1 causes output retrace voltage $V_v$ to be at the maximum positive level that can be supplied from terminal 31a and that is about +20 volts. It follows that, during vertical retrace, between times $t_2$ and $t_4$ of FIGURE 2b, zener diode Zl0 of FIGURE 1 is conducting and transistor Q2 is in saturation that causes transistor Q1 to be in cut-off, since the gate and source electrodes are at the same potential.

Since current $i_v$ of FIGURE 2e is negative at time $t_2$, the beginning of retrace, diode D1 of switching arrangement 32 of FIGURE 1 is back-biased. Therefore, after time $t_2$ of FIGURE 2c, capacitor $C_R$ of FIGURE 1 forms with winding $L_v$ a resonant circuit, tuned to about 2.5 kHz that generates a resonant, negative retrace pulse voltage $V_{CR}$ of FIGURE 2c at terminal 60 of winding $L_v$ of FIGURE 1. Pulse voltage $V_{CR}$ continues until time $t_3$ of FIGURE 2c within retrace. From time $t_2$ to time $t_4$ of FIGURE 2b, voltage $V_v$ at output terminal 31a of amplifier 31 of FIGURE 1 remains at a high level of approximately 20 volts. That high level of voltage $V_v$ is determined by the +20 volt power supply that energizes amplifier 31.

In accordance with an aspect of the invention, each of voltages $V_v$ and $V_{CR}$ are oppositely directed, during at least a portion of retrace. At the end of trace, each changes relative to its corresponding level during trace, to a level that tends to reverse the direction of deflection current $i_v$ after the end of trace. Thus, the retrace portion of voltage $V_v$ and retrace pulse $V_{CR}$ that are at opposite polarities have cumulative effects that speed up the reversal of deflection current $i_v$ during retrace.

The effective retrace time is the sum of interval $t_2$-$t_3$ of FIGURE 2c that is about 200 microseconds and interval $t_3$-$t_4$ that is about 200 microseconds. In contrast, a conventional vertical deflection circuit, where terminals 60 and 61 are at the same potential, as shown by jumper wire 66 in dashed lines, would typically have an effective retrace time of 1400 microseconds.

If a vertical deflection winding having high power losses is used, then, a conventional flyback pulse generator 131, shown in dash lines, may be employed to form retrace pulse voltage $V_v$ at terminal 31a. This enables voltage $V_v$ to be more positive than the maximum positive voltage provided by amplifier 31 as limited by the +20 volt supply voltage. The higher retrace pulse $V_v$ further reduces the retrace interval.

Because of retrace voltage $V_{CR}$ that reduces the retrace interval, the peak positive voltage at terminal 31a may be lower than if retrace voltage $V_{CR}$ were not used. Therefore, voltage stress at terminal 31a on output transistors of amplifier 31 is, advantageously, reduced.

FIGURE 3 illustrates a second embodiment of the invention in which switch 32' utilizes a P-channel type power MOS-FET. Similar numbers and symbols in FIGURE 1 and 3 indicate similar items or functions. In the circuit of FIGURE 3, the control circuit of the gate is, advantageously, simpler than in FIGURE 1. The control circuit includes a resistor $R_{15}'$ that couples voltage $V_v'$ at terminal 31a' to a gate electrode of a P-channel type transistor Q1'. A resistor $R_{PD}$ that is coupled between the gate electrode and a negative power supply voltage causes a 4.7 volt zener diode Z4.7 that is coupled between the gate and source electrodes of transistor Q1' to operate in its avalanche mode during trace. The result is that, during trace, transistor Q1' is turned-on. During retrace, retrace voltage $V_v'$ causes transistor Q1' to turn off.

It should be understood that the use of a P-N-P or N-P-N bipolar transistor with a reverse diode to form switching arrangement 32'', as shown in FIGURE 4a, is also possible. However, this may cause linearity errors in the center of the CRT screen, not shown in the figures, in the crossover region of the transistor and diode. In contrast, as shown in FIGURE 4b, MOS-FET of switching arrangement 32 of FIGURE 1 exhibits better linearity in the crossover region.

**Claims**

1. A vertical deflection apparatus, comprising:
a source of an input signal at a frequency that is related to a deflection frequency;
a vertical deflection winding having a pair of terminals;
a vertical deflection circuit output stage responsive to said input signal and coupled to one of said pair of terminals for developing at said one terminal an output voltage that produces a deflection current in said deflection winding, said output voltage including a retrace pulse portion that produces a corresponding retrace portion of said deflection current during a retrace interval and a trace portion that produces a corresponding trace portion of said deflection current during a trace interval; characterized by
a retrace capacitance ($C_R$) coupled to the other one (60) of said pair (31a,60) of terminals; and switching means (32) coupled to a terminal (61) of said retrace capacitance ($C_R$) and to said other one (60) of said pair of terminals of said deflection winding ($L_V$) for conducting said trace portion of said deflection current ($i_v$) in a manner that bypasses said retrace capacitance ($C_R$) during said trace interval when said switching means (32) is at a first state, and for enabling said retrace portion of said deflection current to flow in said retrace capacitance ($C_R$) when said switching means (32) is at a second state for developing a resonant retrace pulse at the other one terminal (60) of said deflection winding ($L_V$) such that said retrace pulse portion of said output voltage ($V_v$) and said resonant retrace pulse ($V_{CR}$) are oppositely directed pulses during at least a portion of said retrace interval to provide a rapid retrace of said deflection current ($i_v$).

2. An apparatus according to Claim 1 characterized in that said switching means (32) is coupled in parallel with said retrace capacitance ($C_R$) to form a parallel arrangement that maintains said retrace capacitance ($C_R$) discharged during said trace portion of said deflection current ($i_v$).

3. An apparatus according to Claim 2 characterized in that said parallel arrangement is coupled in series with said deflection winding ($L_V$) such that said deflection winding ($L_V$) is interposed between said output stage (31) and said parallel arrangement.

4. An apparatus according to Claim 1, 2 or 3 characterized by means ($R_S$) coupled to said deflection winding ($L_V$) for generating a feedback signal that is representative of said trace portion of said deflection current ($i_v$), and means (33) responsive to said input signal ($V_{in}$) for generating a sawtooth signal ($V_S$), wherein said output stage (31) comprises an output amplifier responsive to said sawtooth ($V_S$) and feedback ($V_{RS}$) signals for generating said output voltage in accordance with a difference therebetween.

5. An apparatus according to Claim 4 characterized in that a peak level of said retrace pulse portion of said output voltage ($V_v$) is limited by a level of a supply voltage (+20V) that energizes said amplifier (31).

6. An apparatus according to Claim 4 or 5 characterized in that said parallel arrangement of switching means (32) with said retrace capacitance ($C_R$), said deflection winding ($L_V$) and said feedback signal generating means ($K_S$) are in series.

7. An apparatus according to Claim 4, 5 or 6 characterized in that said feedback signal generating means comprises a sampling resistance ($R_S$) that is coupled in series with said deflection winding ($L_V$).

8. An apparatus according to any preceding claim characterized in that said switching means (32) has a control terminal (gate) that is coupled to said one terminal of said deflection winding ($L_V$') and said output stage (31').

9. An apparatus according to any preceding claim characterized in that said switching means (32) comprises an FET and a diode that are coupled in parallel.

10. An apparatus according to any preceding claim characterized in that said output stage (31) comprises a pair of transistors that form a push-pull output amplifier such that said one terminal (31a) of said deflection winding is coupled at a junction terminal between said transistors.

11. An apparatus according to Claim 10 characterized in that said output stage further comprises means (131) responsive to said input signal for generating said retrace pulse portion at a magnitude that is higher than a power supply voltage (+20V) that energizes said pair of transistors.

12. A vertical deflection apparatus for a video apparatus comprising;
a vertical deflection winding for conducting therein a deflection current and characterized by
means (31) responsive to a sawtooth signal having a frequency related to a vertical deflection frequency; for generating a first retrace pulse voltage ($V_v$) at a first terminal (31a); and
means (32,$C_R$) responsive to said sawtooth signal for generating at a second terminal (60) a sawtooth output voltage having a retrace pulse voltage portion that is oppositely directed to that of said first retrace pulse voltage ($V_v$) and that is coupled to said deflection winding ($L_V$) such that said deflection winding is interposed between said first (31a) and second (60) terminals.

13. An apparatus according to Claim 12 characterized in that said second retrace pulse voltage generating means comprises a controllable switch (32) that is conductive throughout a trace interval and that is nonconductive at least during a portion of a retrace interval, and a retrace capacitance ($C_R$) that forms a parallel arrangement with said switch (32), said parallel arrangement being coupled in series with said deflection winding ($L_V$) such that during said trace interval said deflection current ($i_v$) bypasses said capacitance ($C_R$) and flows in said switch (32) and during at least said portion of said retrace interval said deflection current bypasses said switch (32) and flows in said retrace capacitance ($C_R$) for developing therein said first retrace pulse voltage ($V_{CR}$) to speed up a reversal of said deflection current ($i_v$).

FIG. 1

$L_V$: 25mH, 10Ω

EP 0 314 461 A2

FIG.2

$f_V = 100Hz$
$V = 10ms$

a  $V_S$  ———— OV
  $6V_{p-p}$  $V_{SO}$

b  $V_V$  +20V  $30V_{p-p}$  OV
  $-10V$

c  $V_{CR}$  OV
  $160V_{p-p}$

d  $V_L$  $130V_{p-p}$  OV

e  $i_V$  $1.2A_{p-p}$  OA
  $200\mu sec$  $200\mu sec$

f  $V_{RS}$  $1.2V_{p-p}$  OV
  $200\mu sec$

g  $V_{GS}$  OV
  $t_0$  $t_1$  $t_2 t_3 t_4$
  $8.2V_{p-p}$

FIG.4a

NPN-TRANSISTOR
AND REVERSE DIODE
$32''$
$i_C$
$i_B$  $V_{CE}$

$i_C$
TRANSISTOR
(EXAMPLE:
$i_B = 100mA$)
$V_{CE}$
DIODE

FIG.4b

MOS-FET AND
REVERSE DIODE
$32$
$i_{DS}$
$V_{DS}$
$V_{GS}$

$i_{DS}$
(EXAMPLE:
$V_{GS} = 6V$)
$V_{DS}$
TRANSISTOR
DIODE

FIG. 3